Europäisches Patentamt

European Patent Office

Office européen des brevets

(19)

(11) **EP 1 536 242 A1**

(12) **EUROPÄISCHE PATENTANMELDUNG**

(43) Veröffentlichungstag:
**01.06.2005 Patentblatt 2005/22**

(51) Int Cl.7: **G01R 29/08**

(21) Anmeldenummer: **03027265.2**

(22) Anmeldetag: **28.11.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(71) Anmelder: **Maschek Elekronik**
**86916 Kaufering (DE)**

(72) Erfinder:
• **Eder, Heinrich, Dr.**
  **81243 München (DE)**
• **Maschek, Hubertus**
  **86916 Kaufering (DE)**

(74) Vertreter: **Motsch, Andreas, Dr.**
**Patentanwälte Motsch & Seitz,**
**St.-Anna-Platz 4**
**80538 München (DE)**

(54) **Elektromagnetfelddosimeter**

(57)   Es wird ein Elektromagnetfelddosimeter zur körpernahen Anwendung für Frequenzen von 80-6000 MHz bereitgestellt, wobei durch Faltung geometrisch verkürzte Antennen (3,4,5) mit Luftdielektrikum und/ oder festem Dielektrikum im Abstand von 1/50-1/4 der jeweiligen Wellenlänge hintereinander und/oder übereinander gestaffelt über einer gemeinsamen Masseplatte (1) angeordnet sind.

Fig. 1

EP 1 536 242 A1

**Beschreibung**

Die Erfindung betrifft ein Elektromagnetfelddosimeter zur körpernahen Anwendung für Frequenzen von 80 - 6000 MHz.

Der Begriff Personendosimetrie basiert primär auf der messtechnischen Summation von physikalischen Ersatzgrößen für Einwirkungen, deren langzeitliche Addition ein Maß für die biologische Schädigung des Organismus darstellt. Der Begriff Dosimeter bzw. Dosis bezieht sich bei ionisierender Strahlung auf die Messung einer in Luft oder Körpergewebe durch Ladungsträger deponierten Energiemenge. Bei nichtionisierender Strahlung, wie sie im Mikrowellenbereich vorliegt, steht die Erwärmung des Gewebes durch Relaxations- und Dissipationsvorgänge im Vordergrund. Dementsprechend wird auch in vorliegender Beschreibung der Begriff Dosis durch die im Gewebe erfolgende Energieabsorption definiert.

Wird die absorbierte Energie auf die Gewebemasse bezogen, spricht man von spezifischer Energie (SA), die in J/kg gemessen wird, oder bei der entsprechenden zeitlichen Ableitung von der spezifischen Energieabsorptionsrate (SAR), die in W/kg gemessen wird. Dabei unterscheidet man eine Ganzkörper-SAR und eine Teilkörper-SAR. Letztere bezieht sich auf eine Gewebemasse von beispielsweise 1g oder 10g.

Die SAR steht nach folgender Gleichung mit der elektrischen Feldstärke im Gewebe in direktem Zusammenhang

$$SAR = \sigma E^2/\rho,$$

wobei σ die Leitfähigkeit, E die elektrische Feldstärke und p die Dichte des Gewebes bedeuten.

Die zeitliche Summation der SAR führt zur SA innerhalb des Messzeitraums und wird als Dosis bezeichnet

Die SAR ist im menschlichen Körper praktisch nicht direkt messbar. Sehr wohl ist die SAR jedoch aus der Messung der in der Nähe der Körperoberfläche gemessenen Feldstärke mittels Simulationsrechnung bestimmbar.

Die Feldstärke ist auch deshalb eine geeignete Messgröße, weil die Grenzwerte nach der 26. Bundesemissionsschutzverordnung (BImSchV) der Bundesrepublik Deutschland in der Einheit Volt/m vorgegeben sind.

Die an der Hautoberfläche gemessenen tangentialen Komponenten der elektrischen und magnetischen Feldstärke stehen in einem direkten mathematischen Zusammenhang mit der in definierter Tiefe im Gewebe auftretenden SAR, wenn man die zugehörige Frequenz, die Hochfrequenzeigenschaften des Gewebes, sowie die Form der Oberflächenkontur des bestrahlten Körpers kennt. Entsprechende Berechnungen werden mit einem Simulationsprogramm (Finite- Difference-Time-Domain-Methode oder kurz FDTD-Methode) durchgeführt.

Die Rückführung auf die SAR kann für bestimmte Einfallsrichtungen der Welle auch messtechnisch durch die Anordnung einer Feld-Messsonde auf einem gewebeäquivalenten Pantom erfolgen, z.B. nach EN 50361, 06/2002, Grundnorm zur Messung der spezifischen Absorptionsrate (SAR) in Bezug auf die Sicherzeit von Personen in elektromagnetischen Feldern von Mobiltelefonen.

Hierzu wird die Feldstärke im definierten Abstand über der Körperoberfläche ermittelt und sodann bei gleicher Feldrichtung mit Hilfe einer Feldsonde die Feldstärke in der darunter liegenden gewebeähnlichen Flüssigkeit gemessen und daraus die SAR berechnet.

Die mit dem Elektromagnetfelddosimeter gemessene oberflächennormale Komponente der elektrischen Feldstärke steht mit der SAR im unmittelbar darunter liegenden Gewebe zunächst nicht in direktem Zusammenhang. Infolge der räumlichen Mittelung bei der Bewegung einer Person und der in Folge Mehrfachreflexion in der Regel mehr oder weniger isotrop vorliegenden räumlichen Verteilung der Feldrichtung sowie der räumlichen Richtungsverteilung der Körperoberfläche kann zumindest eine statistische Beziehung zwischen der quadratisch gemittelten Feldstärke-Normalkomponente und der mittleren SAR hergestellt werden.

Anders steht die von magnetischen Schleifenantennen erfasste tangentiale Oberflächenkomponente des Magnetfelds in direkter Abhängigkeit zur SAR im darunter liegenden Gewebe (N. Kuster, Q. Balzano, Energy Absorption Mechanism by Biological Bodies in the Near Field of Dipole Antennae above 300 MHz, IEEE Transactions on Vehicular Technology, Vol. 41, Nr. 1, Feb. 1992).

Die Messung und Aufzeichnung der Feldstärke am interessierenden Körperteil oder in unmittelbarer Nähe davon kann als die einzige Methode angesehen werden, mit der beispielsweise die Teilkörper-SAR in einer ständig wechselnden Feldumgebung realistisch abgeschätzt werden kann.

Derzeit sind für den Bürger beispielsweise über das Internet nur Expositionsdaten zugänglich, die in der Regel auf Messungen an wenig repräsentativen Standorten im Freien beruhen. Diese Angaben können mit der tatsächlichen individuellen Exposition jedoch nicht oder nur sehr bedingt in Beziehung gebracht werden. Mobilfunk wird jedoch von vielen Bürgern als eine individuelle Beeinträchtigung empfunden. Es besteht deshalb ein großes Bedürfnis nach individueller Information hinsichtlich der persönlichen Exposition im Mobilfunk.

Für epidemiologische Studien sind Langzeit-Expositionsdaten erforderlich. Die Erhebung dieser Daten war bisher mangels geeigneter Personendosimeter nicht möglich. Die deutsche Strahlenschutzkommission spricht sich in Ihrer Empfehlung "Weiterentwicklung der Forschung zum Schutz vor nichtionisierender Strahlung" vom 11./12.04.2002 ausdrücklich für die Notwendigkeit verbesserter Expositionserfassung und Dosimetrie aus.

Der Erfindung liegt die Aufgabe zugrunde, die Belastung durch elektromagnetische, magnetische und elektrische Felder personenbezogen durch ein Elektromagnetfelddosimeter kompakter Bauart und bei minimierter Störung der Messung zu erfassen.

Die Aufgabe wird durch ein Elektromagnetfelddosimeter zur körpernahen Anwendung für Frequenzen von 80 - 6000 MHz gelöst, das dadurch gekennzeichnet ist, dass durch Faltung geometrisch verkürzte Antennen mit Luftdielektrikum und/oder festem Dielektrikum im Abstand von 1/50 - 1/4 der jeweiligen Wellenlänge hintereinander und/oder übereinander gestaffelt über einer gemeinsamen Masseplatte angeordnet sind.

Die erfindungsgemäß eingesetzten Antennen können als Planarantennen oder Faltantennen, wie beispielsweise Falt-Monopole, planare invertierte F-Antennen (englisch: planar inverted F-antenna - PIFA) ausgestaltet sein.

Die Anzahl der Antennen beträgt vorzugsweise 2-12.

Des weiteren können jeweils mehrere Schmalbandantennen zu Multibandantennen zusammengefasst sein.

Die Simulationsrechnung liefert für Falt-Monopole entsprechend ihrer Anordnung in dem erfindungsgemäße Elektromagnetfelddosimeter ein sehr vorteilhaftes Richtdiagramm, das den Halbraum über der Körperoberfläche nahezu gleichmäßig erfasst.

Das Dosimeter ist klein genug, um die Feldlinien-Verteilung um den Körper nicht zusätzlich zu stören. Es kann beispielsweise am Oberarm oder am Kopf getragen werden, wobei es mit entsprechenden Halteeinrichtungen versehen sein kann. Die Masseplatte wird direkt auf den Körper aufgelegt. Die Antennen befinden sich vorzugsweise im Abstand von einer Zehntel Wellenlänge vor der Masseplatte und sind so polarisiert, dass der auf der Körperoberfläche senkrecht stehende elektrische Feldvektor bzw. der magnetische Tangentialvektor erfasst wird.

Die Simulationsrechnung liefert für diesen Abstand eine gute Rückführbarkeit auf die ungestörte Feldstärke, d.h. auf die Feldstärke ohne Person.

Das Dielektrikum ist aus Gründen möglichst geringer Verluste und hoher Empfindlichkeit vorzugsweise Luft. Die Antennen sind ohne weitere Anpassungsglieder nur durch Formgebung und Anordnung an die Impedanz der nachfolgenden Schaltung angepasst. Zur frequenzselektiven Erfassung der Feldstärke können die Antennen schmalbandig ausgeführt sein und/oder mittels Beschaltung mit veränderlichen verlustarmen Reaktanzen, wie Varaktoren, durchstimmbar sein. So können beispielsweise die einzelnen Mobilfunkbänder, auch getrennt nach Basisstation oder Mobilgerät, selektiv ausgelesen werden. Dies kommt einer Spektrometerfunktion nahe.

Um die gegenseitige Beeinflussung zu reduzieren, sind die einzelnen Antennen so über der Masseebene angeordnet, dass ihre Schmalseiten aufeinander zu gerichtet sind. Die Antennen für höhere Frequenzen können aus Platzspargründen unter den Antennen für niedrigere Frequenzen liegen. Dieser gestaffelte Aufbau ergibt in besonders vorteilhafter Weise höchste Kompaktheit.

Ein besonderer Vorteil des erfindungsgemäßen Elektromagnetfelddosimeters besteht in der Personenbezogenheit der Messung. Es kann also nunmehr genau an dem Ort gemessen werden, der für die Beurteilung der Messwerte von größter Relevanz ist, nämlich unmittelbar an der Person selbst. Mit der Ermittlung der nunmehr möglichen Wellenexpositionsdaten hat der einzelne eine Wertangabe, die ihm persönlich zuzuordnen ist. Auf diese Weise können die individuellen Ängste durch die Exposition im Mobilfunk verhindert werden.

In einer weiteren bevorzugten Ausführungsform der Erfindung ist das Elektromagnetfelddosimeter dadurch gekennzeichnet, dass im Luftdielektrikum zwischen den Antennen und der Masseplatte eine oder mehrere Schleifenantennen angeordnet sind. Diese magnetischen Schleifenantennen messen die tangentiale Komponente des Magnetfelds. Die Anordnung der Schleifenantennen im Dielektrikum ist in vorteilhafter Weise besonders platzsparend.

In einer weiteren besonders bevorzugten Ausführungsform des erfindungsgemäßen Elektromagnetfelddosimeters ist die Masseplatte gefaltet , wobei von ihren Schenkeln elektronische Bauteile umfasst sind. Durch diese Faltung erhält die bauliche Anordnung des Elektromagnetfelddosimeters eine besondere Kompaktheit, was wiederum für die Miniaturisierung von großem Vorteil ist. Gleichzeitig wird wegen der effektiven Vergrößerung der Masseplatte eine Erhöhung der Empfindlichkeit erreicht. Die von den Schenkeln der Masseplatte umfassten elektronischen Bauteile dienen vorzugsweise der Spannungsversorgung und der Messelektronik.

Die Speicherung des zeitlichen Feldstärkeverlaufs über einen größeren Zeitraum, wie ein Tag oder eine Woche, lässt die Gewinnung von statistischen Parametern, wie die der 50er, 75er, und der 95er Perzentile der statistischen Feldstärkeverteilung, sowie den Mittel- und den Spitzenwert zu.

Die Daten können nach Aufzeichnungsende über eine Datenschnittstelle zum Rechner übertragen und dort die entsprechenden Parameter berechnet werden.

Wie oben beschrieben, kann ein Näherungswert für die SAR bzw. SA aus den oben dargestellten Zusammenhängen rechnerisch ermittelt werden.

Optional werden die Daten über eine Schnittstelle mittels Lichtwellenleiter oder drahtlos per Funk oder Infrarot zeitsimultan an einen Rechner oder Speicher übertragen.

Die Erfindung wird anhand der Figuren näher erläutert.

Die Fig. 1 zeigt in schematischer Darstellung ein erfindungsgemäßes Elektromagnetfelddosimeter mit drei gefalteten Antennen in der Seitenansicht.

Die Fig. 2 zeigt das Elektromagnetfelddosimeter von Fig. 1 in der Draufsicht.

Die Fig. 3 zeigt in schematischer Darstellung ein erfindungsgemäßes Elektromagnetfelddosimeter mit einer speziellen Anordnung verschiedener Antennen über einer gefalteten Masseplatte in der Seitenansicht.

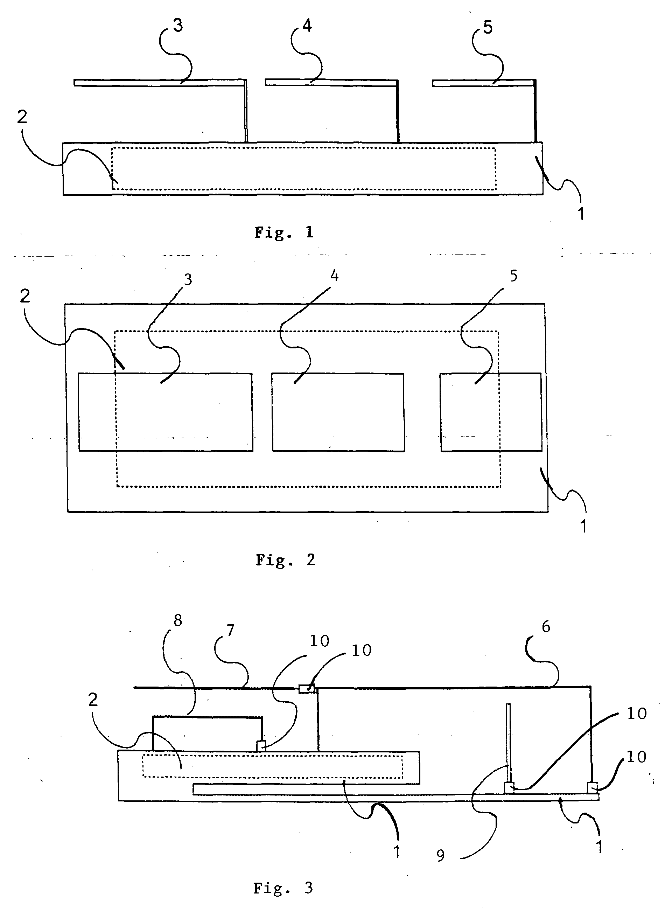

Bei dem Elektromagnetfelddosimeter der Figuren 1 und 2 sind über der Masseplatte 1, die die Elektronik 2 einschließt, drei gefaltete Antennen 3, 4, 5 hintereinander angeordnet.

Die Masseplatte 1 bildet ein geschlossenes Gehäuse, in dem die Elektronik 2 untergebracht ist.

Die Fig. 3 zeigt eine spezielle Ausführungsform der Erfindung, bei der die Masseplatte 1, die die Mess-Elektronik 2 einschließt, gefaltet angeordnet ist. Darüber ist hintereinander ein auf Masse gelegter, gestufter Falt-Monopol 6 und eine an dessen vertikalem Schenkel direkt anschließende shunt-gespeiste Planarantenne 7 angeordnet. Diese stellt eine spezielle Form der planaren invertierten F-Antenne (PIFA) dar. Im Zwischenraum darunter ist ein fest abgeglichener, auf Masse gelegter Falt-Monopol 8 zur Erfassung höchster Frequenzen angeordnet. Im Zwischenraum unter dem gestuften Falt-Monopol 6 ist eine magnetische Schleifenantenne 9 angeordnet. Speiseglieder sind jeweils mit 10 gekennzeichnet. Die horizontalen Schenkel der Faltantennen 6; 7 sind 1,3 cm über der Masseplatte 1 angeordnet.

Das in Fig. 3 beispielhaft beschriebene Elektromagnetfelddosimeter hat Außenabmessungen von 8 cm Länge, 4 cm Breite und 2,3 cm Höhe.

**Patentansprüche**

1. Elektromagnetfelddosimeter zur körpernahen Anwendung für Frequenzen von 80 - 6000 MHz, **dadurch gekennzeichnet, dass** durch Faltung geometrisch verkürzte Antennen mit Luftdielektrikum und/oder festem Dielektrikum im Abstand von 1/50 - 1/4 der jeweiligen Wellenlänge hintereinander und/oder übereinander gestaffelt über einer gemeinsamen Masseplatte angeordnet sind.

2. Elektromagnetfelddosimeter nach Anspruch 1, **dadurch gekennzeichnet, dass** mindestens eine Antenne ein hinsichtlich der Resonanzfrequenz elektrisch abstimmbarer und auf Masse gelegter, gestufter Falt-Monopol ist.

3. Elektromagnetfelddosimeter nach Anspruch 1 oder 2, **dadurch gekennzeichnet, dass** mindestens eine Antenne eine hinsichtlich der Resonanzfrequenz elektrisch abstimmbare Shunt-gespeiste Planarantenne ist.

4. Elektromagnetfelddosimeter nach Anspruch 3, **dadurch gekennzeichnet, dass** bei der Shunt-gespeisten Planarantenne ein Schenkel flach gelegt ist und unmittelbar vom oberen Ende des vertikalen Schenkels eines Falt-Monopols aus speisbar ist.

5. Elektromagnetfelddosimeter nach einem der Ansprüche 1-4, **dadurch gekennzeichnet, dass** mindestens eine Antenne ein hinsichtlich der Resonanzfrequenz fest abgeglichener auf Masse gelegter Falt-Monopol ist.

6. Elektromagnetfelddosimeter nach einem der Ansprüche 1-5, **dadurch gekennzeichnet, dass** die Antennen für höhere Frequenzen im Zwischenraum zwischen Masseplatte und den Antennen für niedrigere Frequenzen angebracht sind.

7. Elektromagnetfelddosimeter nach einem der Ansprüche 1-5, **dadurch gekennzeichnet, dass** im Zwischenraum zwischen den Antennen und der Masseplatte zusätzlich eine oder mehrere magnetische Schleifenantennen angeordnet sind.

8. Elektromagnetfelddosimeter nach einem der Anspruch 1-7 **dadurch gekennzeichnet, dass** die Anzahl der Antennen zwei bis zwölf beträgt.

9. Elektromagnetfelddosimeter nach einem der Ansprüche 1-8, **dadurch gekennzeichnet, dass** mehrere Antennen zu Multibandantennen zusammengefasst sind.

10. Elektromagnetfelddosimeter nach einem der Ansprüche 1-9, **dadurch gekennzeichnet, dass** die Masseplatte gefaltet ist und die Elektronik einschließt.

Fig. 1

Fig. 2

Fig. 3

**Europäisches Patentamt**

**EUROPÄISCHER RECHERCHENBERICHT**

Nummer der Anmeldung

EP 03 02 7265

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 539 567 A (BREWER RICHARD D) 3. September 1985 (1985-09-03) * Zusammenfassung; Abbildungen 3,1 * * Spalte 1, Zeile 19 - Zeile 61 * * Spalte 3, Zeile 18 - Spalte 4, Zeile 8 * --- | 1-10 | G01R29/08 |
| A | DE 36 06 326 A (VOLKRODT WOLFGANG) 3. September 1987 (1987-09-03) * Zusammenfassung; Abbildung 1 * --- | 1 | |
| A,D | KUSTER N ET AL: "ENERGY ABSORPTION MECHANISM BY BIOLOGICAL BODIES IN THE NEAR FIELD OF DIPOLE ANTENNAS ABOVE 300 MHZ" IEEE TRANSACTIONS ON VEHICULAR TECHNOLOGY, IEEE INC. NEW YORK, US, Bd. 41, Nr. 1, 1. Februar 1992 (1992-02-01), Seiten 17-23, XP000297037 ISSN: 0018-9545 * das ganze Dokument * --- | 1-10 | |
| A | US 2001/050636 A1 (WEINBERGER MARTIN) 13. Dezember 2001 (2001-12-13) * Zusammenfassung; Abbildungen 1-4 * * Absatz [0004] - Absatz [0006] * * Absatz [0031] - Absatz [0038] * --- | 1-10 | **RECHERCHIERTE SACHGEBIETE (Int.Cl.7)** G01R H01Q |
| A | US 5 943 020 A (DERSCH ULRICH ET AL) 24. August 1999 (1999-08-24) * Zusammenfassung; Abbildung 1 * * Spalte 3, Zeile 43 - Spalte 4, Zeile 59 * --- | 1-10 | |
| A | US 2003/201942 A1 (SHAMBLIN JEFF ET AL) 30. Oktober 2003 (2003-10-30) * Zusammenfassung; Abbildungen 1A-C,6A-9C * --- -/-- | 1-10 | |

Der vorliegende Recherchenbericht wurde für alle Patentansprüche erstellt

| Recherchenort | Abschlußdatum der Recherche | Prüfer |
|---|---|---|
| BERLIN | 19. Mai 2004 | Ernst, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................................................
& : Mitglied der gleichen Patentfamilie, übereinstimmendes Dokument

EPO FORM 1503 03.82 (P04C03)

**Europäisches Patentamt**

## EUROPÄISCHER RECHERCHENBERICHT

Nummer der Anmeldung

EP 03 02 7265

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 6 380 895 B1 (ROWELL CORBETT ET AL) 30. April 2002 (2002-04-30) * Zusammenfassung; Abbildungen 1,2,4A * --- | 1-10 | |
| A | US 2002/070902 A1 (JOHNSON GREG ET AL) 13. Juni 2002 (2002-06-13) * Zusammenfassung; Abbildung 8; Tabelle 1 * * Abbildungen 2-7 * ----- | 1-10 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| BERLIN | 19. Mai 2004 | Ernst, M |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
................................................................................
& : Mitglied der gleichen Patentfamilie, übereinstimmendes
   Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 03 02 7265

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-05-2004

| Im Recherchenbericht angeführtes Patentdokument | | Datum der Veröffentlichung | Mitglied(er) der Patentfamilie | | Datum der Veröffentlichung |
|---|---|---|---|---|---|
| US 4539567 | A | 03-09-1985 | AU | 3396684 A | 11-04-1985 |
| | | | DK | 209785 A | 10-05-1985 |
| | | | EP | 0155312 A1 | 25-09-1985 |
| | | | JP | 60501230 T | 01-08-1985 |
| | | | NO | 851767 A | 03-05-1985 |
| | | | WO | 8501358 A1 | 28-03-1985 |
| DE 3606326 | A | 03-09-1987 | DE | 3606326 A1 | 03-09-1987 |
| US 2001050636 | A1 | 13-12-2001 | EP | 1024552 A2 | 02-08-2000 |
| US 5943020 | A | 24-08-1999 | DE | 59708915 D1 | 23-01-2003 |
| | | | EP | 0795926 A2 | 17-09-1997 |
| | | | JP | 10056320 A | 24-02-1998 |
| US 2003201942 | A1 | 30-10-2003 | WO | 03092118 A1 | 06-11-2003 |
| US 6380895 | B1 | 30-04-2002 | SE | 511501 C2 | 11-10-1999 |
| | | | AU | 7560398 A | 08-02-1999 |
| | | | AU | 8365998 A | 08-02-1999 |
| | | | CN | 1261988 T | 02-08-2000 |
| | | | CN | 1123086 B | 01-10-2003 |
| | | | EP | 0995231 A1 | 26-04-2000 |
| | | | EP | 0996992 A1 | 03-05-2000 |
| | | | JP | 2001510288 T | 31-07-2001 |
| | | | SE | 9702659 A | 10-01-1999 |
| | | | WO | 9903166 A1 | 21-01-1999 |
| | | | WO | 9903168 A1 | 21-01-1999 |
| | | | US | 6388626 B1 | 14-05-2002 |
| US 2002070902 | A1 | 13-06-2002 | US | 6215447 B1 | 10-04-2001 |
| | | | US | 5945954 A | 31-08-1999 |
| | | | US | 6456249 B1 | 24-09-2002 |
| | | | AU | 2229099 A | 02-08-1999 |
| | | | CN | 1256802 T | 14-06-2000 |
| | | | EP | 0976172 A1 | 02-02-2000 |
| | | | JP | 2001515692 T | 18-09-2001 |
| | | | WO | 9936988 A1 | 22-07-1999 |
| | | | WO | 0133665 A1 | 10-05-2001 |

EPO FORM P0461

Für nähere Einzelheiten zu diesem Anhang : siehe Amtsblatt des Europäischen Patentamts, Nr.12/82